# EUROPEAN PATENT SPECIFICATION

(11) **EP 0 580 408 B1**
(45) Date of publication and mention of the grant of the patent: **03.02.1999**
(21) Application number: 93305698.8
(22) Date of filing: 20.07.1993
(51) Int. Cl.: B23K 26/00

(54) **Excimer laser processing method and apparatus**
Bearbeitungsexcimerlaserverfahren und -vorrichtung
Méthode et appareil d'usinage utilisant un laser excimère

(30) Priority: 20.07.1992 JP 192446/92; 18.03.1993 JP 58989/93
(43) Date of publication of application: 26.01.1994
(73) Proprietor: FUJITSU LIMITED, Kawasaki-shi, Kanagawa 211 (JP)
(72) Inventor: Yamagishi, Yasuo, Kawasaki-shi, Kanagawa 211 (JP); Shimizu, Kanae, Kawasaki-shi, Kanagawa 211 (JP); Mizutani, Daisuke, Kawasaki-shi, Kanagawa 211 (JP); Owada,Tamotsu, Kawasaki-shi, Kanagawa 211 (JP); Ishizuki, Yoshikatsu, Kawasaki-shi, Kanagawa 211 (JP); Hashii, Hideya, Kawasaki-shi, Kanagawa 211 (JP)
(74) Representative: Abrams, Michael John

(56) References cited:
- WO-A-91/11090
- DE-A- 3 913 785
- US-A- 5 073 687
- PATENT ABSTRACTS OF JAPAN vol. 017, no. 222 (M-1404)7 May 1993
- & JP-A-435688 (FUJITSU LTD) 10 December 1992

## Description

The present invention relates to an excimer laser processing method and apparatus

In recent years, attention has been drawn to an ablation processing method using an excimer laser.

An excimer laser is a gas laser using excitation of a rare gas and a halogen and emits a high intensity ultraviolet beam. Ordinary substances exhibit a strong absorption to ultraviolet beams, and therefore, when irradiated by a strong radiation pulse (e.g. about 100 MW/cm²) such as of excimer laser radiation, chemical bonds are destroyed in instant and the surface layer evaporates (ablation). This phenomenon is used in excimer laser processing. There are numerous combinations of rare gases and halogens, but those used most often for processing materials are KrF (wavelength of 248 nm), XeC1 (wavelength of 306 nm), and KrF (wavelength of 193 nm).

In laser processing, use has been made of the heat energy of infrared beams such as YAG and Co₂ lasers, but such processing results in a large surrounding heat damage. The beam is focused for the processing, but it is difficulty to make the diameter of the beam spot sufficiently small since infrared light has a long wavelength. Also, since spot processing is involved, there is the problem that the throughput cannot be improved.

As opposed to this, an excimer laser mainly makes use of the process of breakup of chemical bonds by light, and therefore, the processed cross-section is clean in finish. Also, it is possible to process a relatively wide area (e.g. up to about 10 mm²) at one time, and therefore, there is the feature that a fine pattern can be easily formed by exposure through a mask. (See for example T A Znotins et al; Laser Focus, 54, May 1987, Ishizaka: Applied Mechanical Optics, September 1990 issue, etc).

An excimer laser can be used for processing or marking metals or ceramics, but is most impressive when it comes to processing polymers. Studies are under way on applications to polyimides and other difficult-to-process polymers.

Among the fields where attention is being drawn to the usefulness of ablation processing by excimer lasers is the formation of holes (i.e. via hole processing) for connection of wiring between layers in the layer insulation films of multilayer wiring substrates. Circuit substrates are being made multilayer in construction to enable higher density packaging of electronic components, and circuit patterns are being made finer as well. Therefore, even in circuit substrates, attention is being drawn to the thin film method of laying wiring one layer at a time in the same way as multilayer wiring in semiconductor devices. The thin film method has been long known to be suited for high density packaging, but there have been few cases of actual application owing to difficulties in formation of via holes for connection between layers. Due to the requirements for heat resistance at the time of soldering use is made mainly of polyimide, which has a superior heat resistance, as the thin film insulating material, but in the thin film method, the thickness of the insulating film on the circuit substrate is several tens of microns, which is an order of thickness greater than that of the semiconductor device. Accordingly, it was difficult to form fine holes in a difficult-to-process material like a polyimide by a reliable, convenient process.

For example, in a process for etching using pattern exposure of a heat curing material, there are the problems of difficult of light penetrating to under the film and the problem of holes of only a size up to 3 times the thickness of the film being able to be formed at most in wet etching by a solvent and a reverse tapering of the hole in section shape, making miniaturization impossible.

In the dry etching process where a resist film is formed on the resin film finer holes can be formed, but the process is complicated and further it is difficult to find a resist suited to a polyimide (one with large selectively in etching).

As opposed to this, ablation processing by an excimer laser enables formation of holes with an extremely good shape faithful to the mask by a process of simply exposing the resin film to irradiation, so has been coming under focus as a good technique for making via holes in difficult-to-process films.

One of the problems in the case of forming via holes is how to monitor and manage the progress of processing. In excimer laser processing, the resin film is etched to a thickness corresponding to the intensity of the light with each of a series of successive shots. The processing proceeds until the underlying electrodes are exposed. Accordingly, when the number of irradiation shots is insufficient or the intensity of the light drops for some reason or another, or else when the film to be processed has locally thicker areas, the electrodes will not be exposed and defective connection between layers will result. On the other hand, when the number of shots is excessive, not only is time wasted in processing, but also the underlying electrodes may be damaged and the heating of he electrode metal may cause heat deterioration of the resin film.

Therefore, it is necessary to monitor the state of progress of processing so as to enable the processing to be ended at the required sufficient number of shots. In the past, the number of irradiation shots had been set by determining certain conditions in advance, but the number of necessary shots varies due to fluctuations in the output of the laser, changes in the distributions of light intensity in the beam, deterioration of the optical components, variations in film thickness. Thus, there was the problem that it was necessary to frequently reset the conditions.

In DE-39 13 785, for example, the light emitted during the processing is monitored by two detectors, one for detecting light emitted by the film and the other for detecting light emitted by the underlying electrodes. Thus it is possible to detect when the resin layer has been removed.

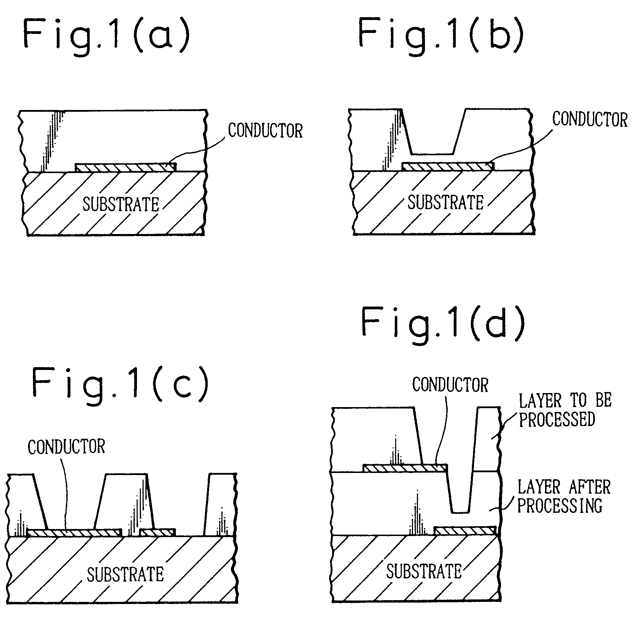

It is desirable during the production of via holes to inspect for processing defects. Such an inspection process is desirable no matter which method is adopted for making the holes. In particularly, in a multilayer think form circuit, when defects in the lower layer are overlooked in many cases all the processes applied on top of it become wasted. Therefore, stringent checks which do not allow any mistakes are desirable. In many cases, this requires more steps than just those for forming the via holes itself and necessitates expensive facilities. There are various types of processing defects which can be roughly classified into the following:
(a) No via hole is made at a location where such a hole should be made (see Fig. 1(a)).
(b) The via hole does not reach the underlying electrode (conductor) (see Fig. 1(b)).
(c) A hole is made at a location where no hole should be made (see Fig. 1(c)).
(d) The via hole deviates in position from the intended underlying electrode (conductor) (see Fig. 1(d)).

Various optical techniques for inspecting for defects, which involve the detection of light reflected from the surface of the insulating material, fluorescence from the insulating material, etc. and extraction of contours using the same have been developed and put into practical use, but with contour extraction of reflected surface light it is difficult to detect the defects of Fig. 1(b) and (d), although the defects of Fig. 1(a) and (c) can be detected. When the insulating material is transparent and the circuit consists of only a single layer, it is possible to inspect for deviations in position as in Fig. 1(d) by using the light reflected from the supporting substrate such as Si and the light reflected from the insulating film for pattern recognition and comparing the two against each other, but when the circuit consists of multiple layers, the wiring of a layer below the wiring layer where the via holes are formed becomes an obstacle making inspection difficult.

According to a first aspect of the present invention, there is provided an excimer laser ablation processing method of forming via holes in a resin film, by subjecting portions of that film to radiation from an excimer laser and by employing light emitted as a result of decomposition of the irradiated portions of the film during formation of such holes to monitor progress of the hole formation, characterised further by the steps of a) detecting the positions of said irradiated portions on the film by using said emitted light, b) comparing the detected positions with respective preset design positions and c) using said comparison of said positions to inspect for processing defects.

According to a second aspect of the present invention, there is provided an ablation processing apparatus, for use in forming via holes in a resin film, comprising means for subjecting portions of that film to radiation from an excimer laser, and means for monitoring the progress of the hole formation, whilst said portions are subjected to said radiation, by employing the light emitted as a result of decomposition of the irradiated portions of the film during formation of said holes, characterised further by a) means for detecting the positions of said irradiated portions on the film by using said emitted light, b) means for comparing the detected positions with respective preset design positions and c) means for inspecting for processing defects by using said comparison of said positions.

Preferably the irradiation of the said portions is terminated upon detection of a predetermined change in intensity of the emitted light.

Reference will now be made, by way of example, to the accompanying drawings, in which:
Fig. 1, discussed above shows views of sectional views illustrating types of defect in excimer laser processing [(a), (b), (c) and (d)];
Fig. 2 is a graph showing a spectrum of light emission in the visible range at the time of ablation of a polyimide resin by a KrF excimer laser;
Fig. 3 shows graphs illustrating the respective spectra of light emission in the visible range in the case of ablation of polyimide resin by a Krf excimer laser in H₂, He and O₂ gas atmospheres;
Fig. 4 shows a schematic side sectioned view of an excimer laser ablation processing apparatus;
Fig. 5 shows a partly perspective view of a second such apparatus;
Fig. 6 shows a schematic side sectioned view of an excimer laser ablation processing apparatus operable in accordance with a first embodiment of the present invention.
Fig. 7 shows a schematic side sectioned view of an excimer laser ablation processing apparatus operable in accordance with a second embodiment of the present invention;
Fig. 8 shows a schematic plan view of a region of incidence of a beam produced by the laser in the apparatus of Fig. 7;
Fig. 9 shows a schematic side sectioned view of another excimer laser ablation processing apparatus (not embodying of the present invention);
Fig. 10 illustrates graphically how results achieved vary with a dimensional parameter of an excimer laser ablation processing apparatus as shown in Fig. 4, 7 or 9;
Fig. 11 shows a graph illustrating the relationship between the taper angle of a via hole produced in a resin film by means of such apparatus and the intensity of the laser beam; and
Fig. 12 shows a sectioned side view of parts of such an apparatus.

Light emission from plasma generated by the decomposition of a resin film can be monitored so as, for example, to detect exposure of an underlying electrode, whereby the endpoint of the process can be determined. In an embodiment of the present invention, positions of such emitted light are detected by monitoring the light emission, and are compared with respective preset design positions. The coincidence or noncoincidence between the two can then be used to inspect the results of the processing for the presence of defects.

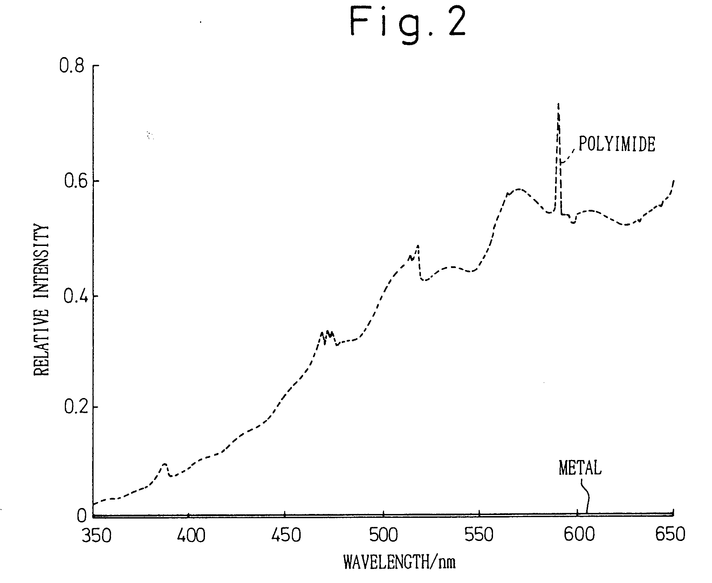

When a resin layer decomposes due to laser ablation, the fragments thereof become plasma and emit light. Figure 2 shows the spectrum of light emission in the visible range during ablation of a polyimide resin by a KrF excimer laser. When a via hole is fully formed in the resin and an underlying metal part is exposed, light emission due to decomposition of the resin stops, so that a very notable decrease in the intensity of the light emission occurs. Accordingly, by detecting the intensity of light emitted from a particular processing point, it is possible to detect completion of the required processing. Feeding back this information to the laser control system can enable the processing to be terminated so as to minimize the period of irradiation.

At the position of formation of a via hole through a resin film, the start of irradiation by a laser pulse results in the resin (insulating material) being ablated and its decomposition gas emitting light. As ablation proceeds due to repeated irradiation, the hole becomes deeper. When the bottom of the hole reaches an underlying electrode, the ablation stops, and therefore light is no longer emitted. By detecting at what position light is emitted, using a monitor camera or other optical means, and comparing the coordinates of the light emitting position with preset design data for the holes to be formed, it is possible to detect whether a defect exists, such as that shown in Fig. 1(a), an absence of a via hole, or that shown in Fig. 1(c), an incorrectly positioned via hole. With an increase in the number of irradiation shots, the underlying electrode is exposed and the light emission from the position first emitting light stops, but when the resin film is locally built up due to, for example, foreign matter in the resin film, the electrode will not be exposed at the position (as shown in Fig. 1(b)) and the emission of light at that position will continue. It is thus possible to detect inadequate exposure of an electrode. In addition, when the defect of Fig. 1(d) occurs, due to the deviation of the position of the underlying electrode or the defective positioning of a laser processing mask, light emission from most of the holes will stop after a certain number of shots, but the defective positions will continue to emit light, and it is thus possible to identify those positions as being positions where defects exist.

It should be noted that the above-mentioned defects occur in excimer laser processing involving exposure through a mask in the following cases:

Fig. 1(a) Absence of hole: Occurs when the appropriate gap is not provided by the patterning of the mask, but this seldom proves a problem since the mask is usually inspected before use.

Fig. 1(b) Incomplete penetration: This occurs due to defects in the formation of the film, such as uneven coating of the resin film or foreign objects. There is a possibility of relatively frequent occurrence.

Fig. 1(c) Pinhole defects (extra hole formed): This arises due to pinholes in the mask, so does not provide a problem in a mask comprised of a metal sheet with holes made it is, but may occur with a mask comprised of a patterned quartz glass sheet on which a light shielding layer is formed. In addition to any initial defects, such defects sometimes arise due to deterioration of the light shielding layer with repeated use.

Fig. 1(d) Poor positioning: This includes poor positioning of the via hole formation mask and poor positioning at the time of formation of the underlying electrode pattern. In multilayer circuits, poor positioning often accumulates. This is a defect arising not from the processing step itself, but from a previous step.

In practice, to facilitate correction of the processing method, it is desirable to identify the positions of the defects. Identification of a defective via hole requires a precision of ±50% of the pitch between via holes. In excimer laser processing, the smallest via hole diameter industrially possible is about 20 µm (opening portion). In this case, the basic grid is expected to be about 100 µm. Therefore ±50 µm is required. This level of precision is fully achievable by detection of positioning marks on the substrate being processed through a monitor camera and calculation of the distance from there. Caution is required in detection of the position in that the light emission does not occur just from the processing surface, but occurs from the plasma generated by the processing. Therefore, the region emitting light is wider than the diameter of the hole being processed. By adjustment of the gain of the monitor camera, however, it is possible to suppress the spread of the portion emitting light to about 20 µm. Considering that the pitch in the basic grid is about 100 µm at the smallest, the rider spread of light does not prevent identification of a defective via hole.

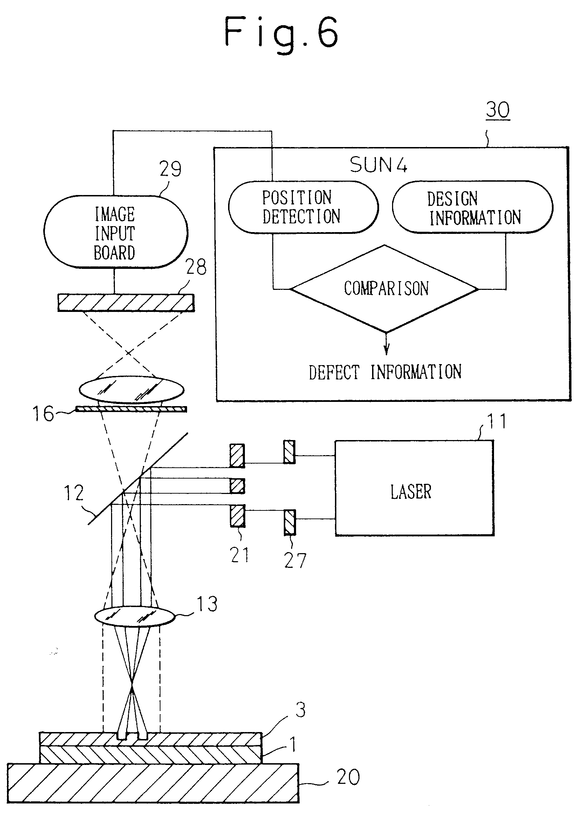

When processing by a projection exposure method, as shown in, for example, Fig. 6, explained later, it is possible to set the path of laser processing light and the path of light for monitoring so that emitted light from a processed area can be received directly by a camera, but in contact exposure where a mask is laid over the processed surface during processing it is necessary to detect the light emitted from the processed portion passage through the mast. In the latter case it is difficult to detect the light emitted from the processed portion if the light shielding layer of the mask is a metal film. This problem can be solved by making the light shielding layer of a dielectric multilayer film which selectively reflects only the oscillation wavelength of the laser. Such a layer can shield against laser light, whilst being transparent to visible light, thereby making it possible to observe the light emitted from the processed portion through the mask.

As mentioned above, excimer laser ablation enables the formation of very well-shaped holes faithful to a mask by a simple process of exposure, and, as a result, has been coming under attention as a technique for processing via holes in difficult-to-process films such as polyimide film. There is, however, a problem of deposition of soot on areas around the processed portions when patterning a polymer by an excimer laser. This soot can cause a decline in the insulation resistance of the surface in the case of a multilayer wiring substrate, so removal of the deposited soot is required. To remove the soot, there is a method involving immersion in alcohol, or another liquid having a low surface tension, and Performing ultrasonic cleaning there, but is difficult to remove the soot completely and the black stain at the deposition area cannot be removed. Another method is to perform the processing while blowing helium gas or hydrogen gas. However, the use of helium gas involves higher costs and the use of hydrogen gas involves a danger of explosion.

However, it has now been formed that generation of soot is suppressed by maintaining an oxygen gas atmosphere, which is both high in combustion effect and inexpensive, in the vicinity of the surface of the organic material being subjected to ablation processing by the excimer laser. Further, the resulting increased intensity of the light emission facilitates detection for the emitted light and thereby enables more reliable inspect of the results of the processing.

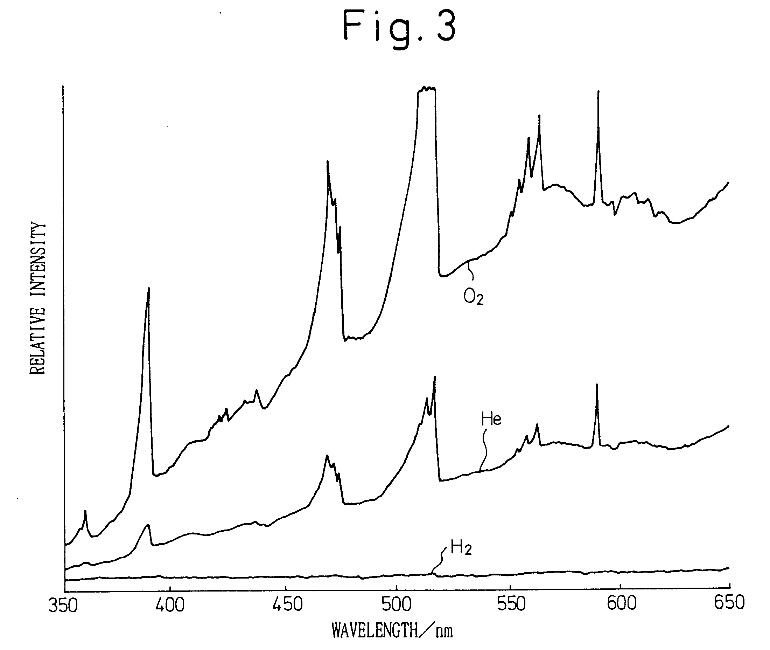

Figure 3 shows spectra of light emission in a visible range during ablation of a polyimide resin by a KrF excimer laser in respective atmospheres of helium gas (He), oxygen gas (O₂), and hydrogen gas (H₂). In the case of a hydrogen gas atmosphere, almost no light emission is detected, while in the case of helium gas the intensity of the light emission is low. As opposed to this, in the case of oxygen gas the intensity of the light emission increases substantially and the light emission can be sufficiently detected even through a mask.

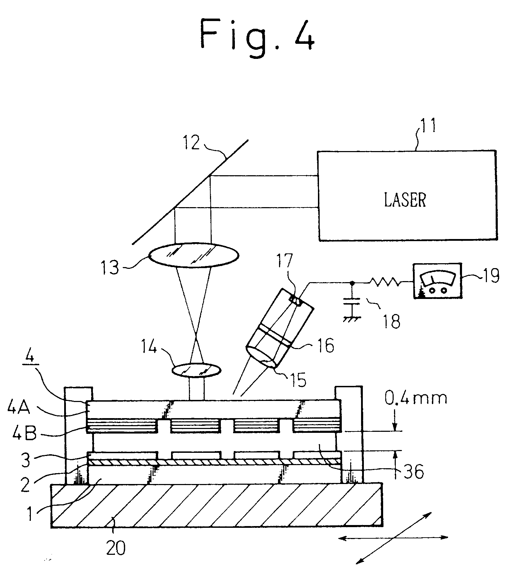

In an example shown in Fig. 4, a copper (Cu) film 2 having a thickness of 2 µm was deposited on a glass substrate 1 by sputtering. On the top thereof, a polyimide film (Hitachi Kasei PIX-3500) was coated to form a resin film 3 having a thickness of 40 µm. Above the film 3 was placed a mask 4, at a spacing of 0.4 mm. The assembly was affixed on an XY-stage 20. The stage was repeatedly moved in a zigzag manner and a laser 11 fired by way of a mirror 12 and lenses 13 and 14 to form holes of a diameter of 50 µm, in a 3 cm square region of the film 3, at a longitudinal and lateral pitch of 0.25 mm.

The processing conditions were as shown below:
Output wavelength of laser: 248 nm (KrF)
Output power: 300 mJ/pulse (pulse width 16 ns)
Repetition frequency of pulse: 200 Hz
Mask: Synthetic quartz substrate 4A on which is formed dielectric multilayer film 4B having pattern of holes of diameter of 40 µm
Exposure intensity: 1.0 J/cm² per pulse
Speed of travel in X-direction (main scanning direction) : 40 mm/s (stroke 35 mm)
Steps in Y-direction (secondary scanning direction) : 2 mm x 18 steps
   The ablation processing was performed under the above conditions and the light emission during the processing was received by a photodetector 17 through a lens 15 and a color filter 16 capable of passing visible light of 500 to 700 nm wavelength. The average output over time was measured by a power meter 19 through an integration circuit 18.

The mask 4 was transparent to visible light, and therefore it was possible to monitor the light emission. The amount of light received in the first and second scanning was 300 µW, but fell to 200 µW in the third scan and become less than 10 µW in the fourth scan. Therefore, no fifth scan was performed, the processing being ended.

The processed holes were examined, and as a result it was confirmed that all were formed as complete via holes and there was no damage to the underlying Cu film.

### Example 2

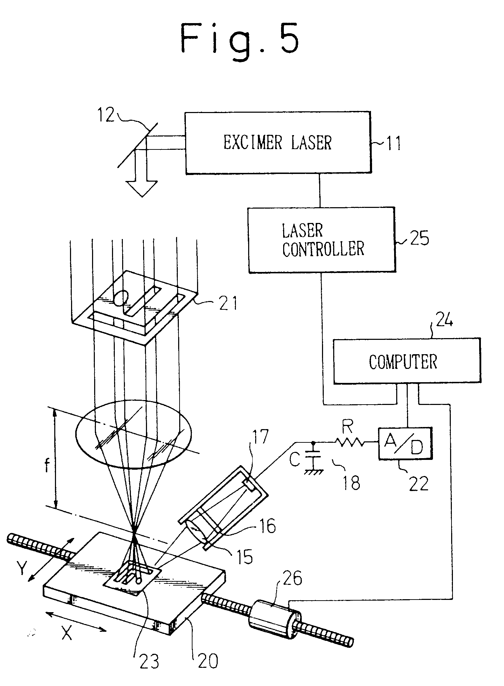

In an example shown in Fig. 5, an aluminum (Al) film having a thickness of 3 µm was deposited on a glass substrate by sputtering. On the top thereof a benzocyclobutene-based heat curing resin (available from Dow Chemical Co.) was coated to form a resin film having a thickness of 30 µm.

The laser light of the excimer laser 11 was passed through an aperture having a size of 5mm x 20 mm to cut off peripheral portions of the laser beam and to pass the portion with a uniform light intensity. Then the light was passed through a mask 21, comprised of a 0.2 mm copper sheet in which holes of a diameter of 0.4 mm had been made at a pitch of 1 mm by a drill, and a lens which effectively reduces the mask by a factor of 4 for the processing. In the same way as in Example 1 above, the light emission was received by a photodetector 17, the amount of received light was measured through an integration circuit 18, which consists of a capacitance C in series with a resistance R, for each pulse in synchronization with the laser output, and the result was input to a computer 24 after A/D conversion by an A/D converter 22. The average light intensity (Iₒ) of the first five pulses after the start of the processing was found. When the light intensity measured for a subsequent pulse fell below 10 percent of the value Iₒ for the first five consecutive pulses, the laser controller 25 was actuated by instruction from the computer 24 to stop the operation of the laser 11. A stage 20 carrying the workpiece (i.e. the substrate coated with resin film to be processed) 23 was then moved by 10 mm, by a step motor 26, and the processing was then again performed. In this way, the processing was performed by a step and repeat process.

As a result, it was possible to expose the underlying Al film at all desired hole positions without causing damage to the underlying Al film.

### Example 3

In an embodiment of the present invention, an underlying copper (Cu) film (not shown) was sputtered onto a glass substrate 1 and lithographic techniques were used to form a pattern of electrodes of 60 µm⌀ in a lattice form at a pitch of 200 µm. A polyimide film 3 (Hitachi Kasei PIX-3500, thickness of 20 µm) was formed on the top thereof and then was processed to form via holes by an exposure system shown in Fig. 6. A mask 21 was made of a molybdenum sheet, of a thickness of 0.2 mm, in which holes of 0.2 mm⌀ were formed in a lattice with a pitch of 0.8 mm by an electrodischarge processing method. A projection exposure method was performed, at a reduction factor of 4.0, in which laser light emitted from the laser 11 was passed through an aperture 27, having a size of 8 x 20mm, to remove peripheral portions of the beam and then directed on to the mask 21 by way of a reducing lens 13 to process a region having a size of 2.0 x 5.0 mm on the film 3. For the laser 11, use was made of a Lumonics EX700. The laser output wavelength was 248nm KrF), the intensity of exposure was 0.7J/cm² per pulse, and the pulse repetition frequency was 100 Hz. The light emitted from the processed region was passed through a dielectric multilayer film mirror 12 and monitored by a CCD camera, through which visible light passes. It should be noted that, for the CCD photo element 28, use was made of one with a high resolution of 1000 x 1000 elements.

The image taken was passed through an image input board 29 and input every 0.1 sec to a frame memory 30 of the work-station. It was compared repeatedly against present design information designating via holes at all lattice points at a pitch of 200 µm at intervals of 0.1 sec, to judge for the presence and mode of defects at every processing point in the design information. The position and mode of any detected defective portions was shown in a display.

### Detection of Modes of Fig. 1(a) and Fig. 1(c)

Metal pieces were adhered to the mask 21 to block four holes. Also, two holes of 0.2 mm⌀ were made in the mask at positions other than the lattice points. Exposure was then performed. The four absent holes corresponding to the blocked mask holes were detected as deffects of type (a), and the positions corresponding to the two mask holes made at locations other than the lattice points were detected as defects of type (c).

### Detection of Mode of Fig. 1(b)

A polyimide film having a thickness of 25 µm was cut into 1 mm squares and placed in a polyimide varnish. The result was coated on a substrate 1 on which electrodes had been formed so as to form locally uneven film portions. A location with one such film protrusion was processed using a normal mask. Irradiation was performed a further 0.5 second after the cessation of the light emission from 150 points among 250 light emission points and the location last emitting light was detected. As a result, the portion of the film built up by the presence of the film protrusion was displayed on the screen as a defect of type (b).

### Example 4

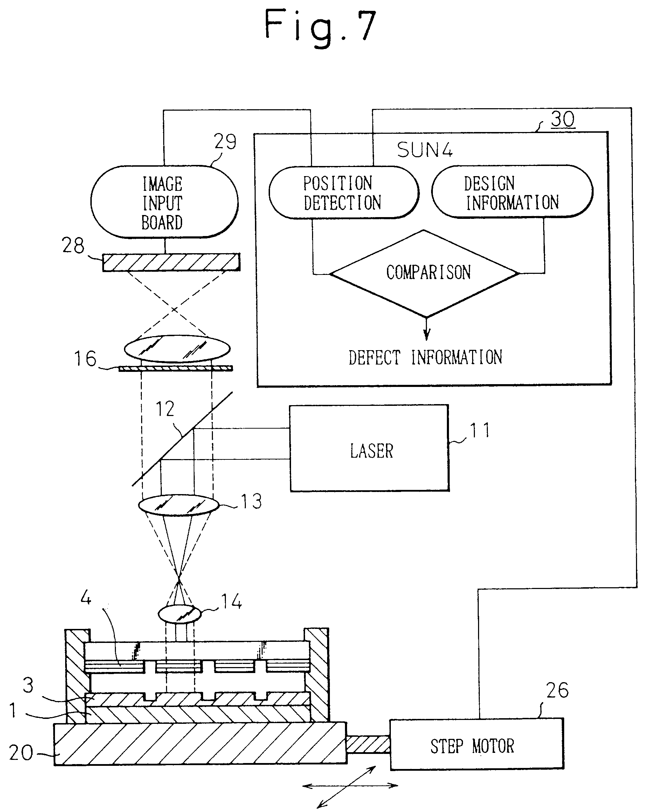

In a second embodiment of the present invention, electrodes having a size of 40 µm⌀ were formed at a pitch of 200 µm in a 5 cm square region on a 7 cm square glass substrate 1 (Fig. 7) in the same was as in Example 3. On the top thereof, a benzocyclobutene heating curing resin (available from Dow Chemical Co.,) thickness of 25 Km) was formed as the resin film 3. Further, an SiO₂/Y₂O₃ dielectric multilayer film was laid on a synthetic quartz substrate having a thickness of 1 mm and 7 cm square to form a multilayer film mirror for 248 nm light. Holes having a size of 30µm⌀ were formed in a 5 cm square area in the 7 cm square region at a pitch of 200 µm, thereby forming the mask. The resin film and mask were positioned facing each other with a gap of 0.3 mm therebetween. Then the two were fixed together and placed on the XY-stage 20 as shown in Fig. 7. The laser light was focused by the first lens 13 so as to give 0.8 J/cm² per pulse at the beam centre, then was converted to parallel light by the second lens 14 and passed through the dielectric mirror mask 4 to irradiate the workpiece. The laser 11 and the oscillation frequency were made the same as in the embodiment of Fig. 6.

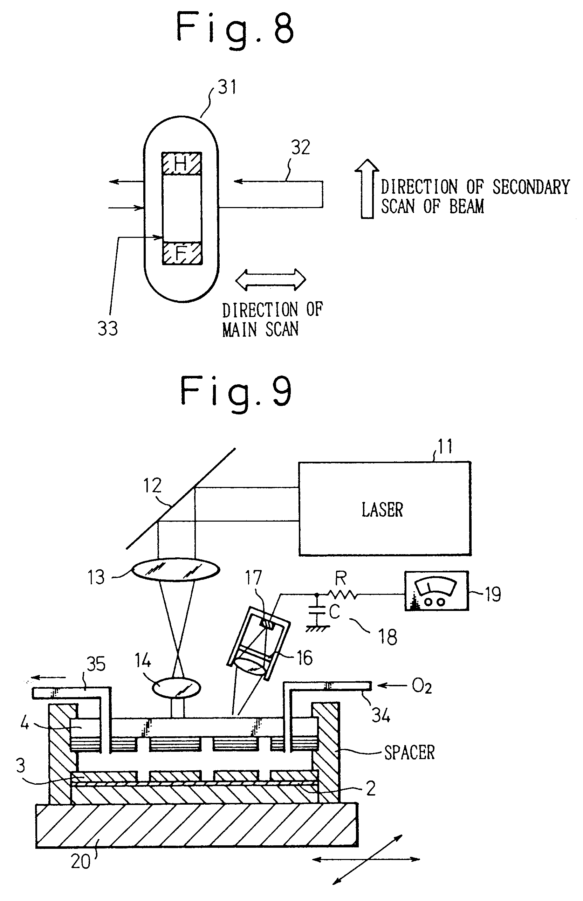

While irradiating with the laser light 11, the XY-stage 20 was moved 20 mm/s in the X-direction. When the pattern edge was passed, the stage was fed 1 mm in the Y-direction and then similarly moved in the X-direction. The entire surface was therefore processed by this scanning in a zigzag pattern. The light emission at this time was passed through the mirror mask 4 and monitored in the same way as in Example 3. In the same way as Example 3, the light emission was sampled each 0.1 seconds. The coordinates of the light emission points at that time were compared with signals from the step motor 26 moving the XY-stage 20 and calculated and compared against the design information to detect defects. In this embodiment, the size of the beam was about 3 x 8 mm at the irradiated portion 31 (shown in plan view Fig. 8). The laser beam was repeatedly irradiated by a zigzag scan 32. A 2 x 6 mm region 33 at the centre of the irradiated beam was monitored. The light emission positions at the leading portion (i.e. H in Fig. 8) in the direction of progression of the processing were detected (i.e. for use in detection of above-mentioned defects (a) and (c)), and the exposure of the electrodes at the final portion (i.e. F in Fig. 8) was detected for use in identifying defects (b) and (d).

Processing was performed by the above-mentioned method, using a mask having defects corresponding to types (a) and (c). Resulting defects of these types were detected, by the defect inspection method using the light emitted during the processing, locations corresponding to the mask defects.

### Example 5

In the example shown in Fig. 9, a glass substrate 1 carries a metal (Cu) film 2 on which a polyimide film (Hitachi Kasei PIX-3500, thickness of 30 µm) was formed as a resin film 3. This film processed by the exposure system shown in Fig. 9 to form holes having a size of 50 µm⌀ at a longitudinal and lateral pitch of 0.25 mm in a 3 cm square region.

The processing conditions were as shown below:
Laser oscillator: Lumonics EX-700
Oscillation wavelength: 248 nm (KrF)
Output: 300 mJ/pulse (pulse width 16 ns)
Exposure intensity: 1.0 J/cm² per pulse
Number of irradiation pulses: 200 pulses/shot
Reduction rate: 4:1
Flow of oxygen gas: 2 litres/minute
   Ablation processing was performed under the above conditions. A comparison was made of the generation of soot when introducing O₂ from the oxygen gas inlet 34, as compared with introducing hydrogen and helium gas instead of O₂, and as compared with processing in the atmosphere. The amount of the soot was evaluated by the radio of T₁/T₀, making a comparison of the average transmittance (measured by 5 mm⌀ light, spatial average) T₁ of soot deposited directly after the processing and the average transmittance T₀ after removal of the soot by rubbing cleaning. It was found that T₁/T₀ was about 50% for processing in the atmosphere, about 95% in the case of passing hydrogen gas, about 87% in the case of helium gas, and about 84% in the case of oxygen gas. Thus oxygen gas has substantially the same effect in reducing soot as hydrogen gas and helium gas.

Further, ablation processing was performed under the above conditions, the light emission during the processing was received by a photodetector 17 through a filter 16 passing visible light of 500 to 700 nm, and the average output along with time was measured through an integration circuit 18. The mask 4 allowed about 90% of the visible light to pass through it, and therefore the light emission could be measured. The exposure system of Fig. 9 was affixed on the XY-stage 20 and processing was performed by the laser light emitted from the laser 11, while moving the stage 20 in a zigzag pattern. The speed of movement in the X-direction at this time was made 40 mm/s and the steps in the Y-direction were made 2 mm x 18 steps. The amount of light received in the first scan was 450 µW in the case of an oxygen gas atmosphere, but was 40 µW in the case of a helium gas atmosphere. Almost no light emission could be observed in the case of a hydrogen gas atmosphere. Further, in the case of an oxygen gas atmosphere, a drop in the intensity of light emission was clearly seen in the fourth scan and the endpoint of the processing could be easily judged, but in the case of a helium and hydrogen gas atmosphere it was not easy to conclusively determine the endpoint of processing.

As explained above, in this example, by maintaining an oxygen gas atmosphere in the vicinity of the processed surface in excimer laser ablation processing it is possible to effectively suppress the soot created at a low cost and to increase the intensity of light emission of the polymer ablation, thereby facilitating reliable determination of the completion of processing by detection of light emission.

### Example 6

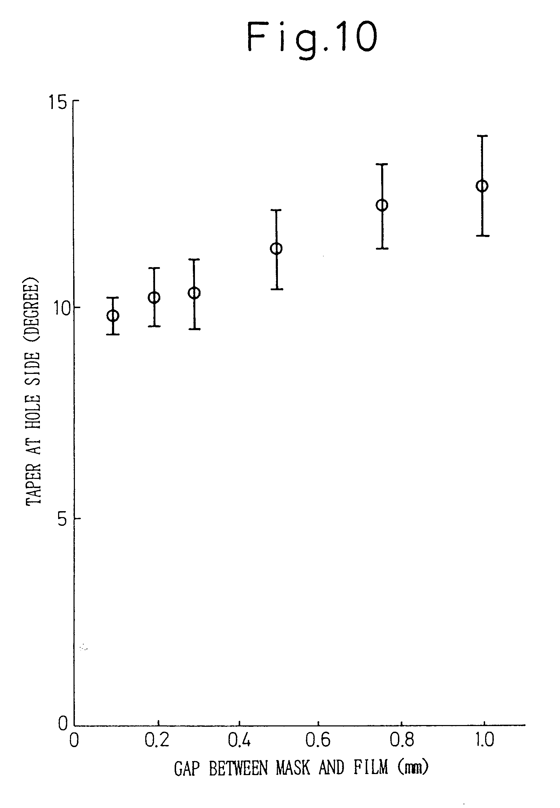

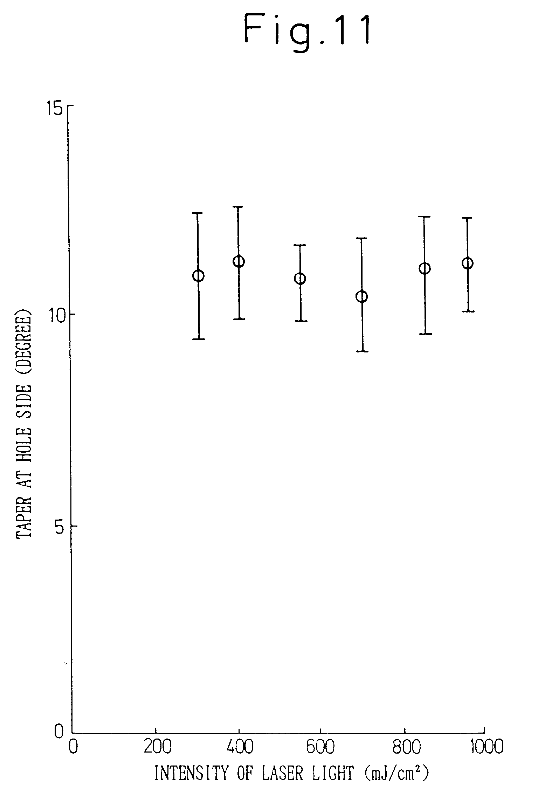

An excimer laser processing method (i.e. an equal size mirror mask method) such as that illustrated in Figs. 4, 7 and 9 should preferably be capable of reliably forming holes of a desired diameter and a desired taper angle, one of the goals of formation of via holes for interlayer connection in a polymer by an excimer laser in accordance with the trend toward diverser types of packaging and miniaturization of patterns. The apparatus requires, however, provision of a gap 36 (Fig. 4) of 0.1 to 1 mm between the processing surface 3 and the mask 4 to allow the ablation gas to escape. When a mask having a pattern of holes having a size of 5 to 50 µm diameter was used for the exposure, and the relationship between the size of the gap and the shape of the holes formed was examined, it was learned that, mainly because the output beam of an excimer beam may not be precisely parallel increased size of the gap 36 causing the diameter of the openings formed to become larger than the diameter of the holes of the mask, and the shape of the openings also becomes oblate, and at the same time the taper angle also becomes larger (as shown in Fig. 10). Further, it was learned that there is no particular correlation between the intensity of the laser light and the taper angle (see Fig. 11). These results suggest that it may be desirable to be able to control the gap in units of 0.1 mm, so as to enable holes to be made of a desired diameter and a desired taper angle in a film to be processed having a certain thickness. In the past the practice has been to place a spacer having a certain thickness, of 0.5 mm or 1 mm, between the mask 4 and the film 3 to form the gap, so that fine adjustment was difficult and, further, the spaces had to be changed one by one depending on the requirements for the via holes or the film to be processed.

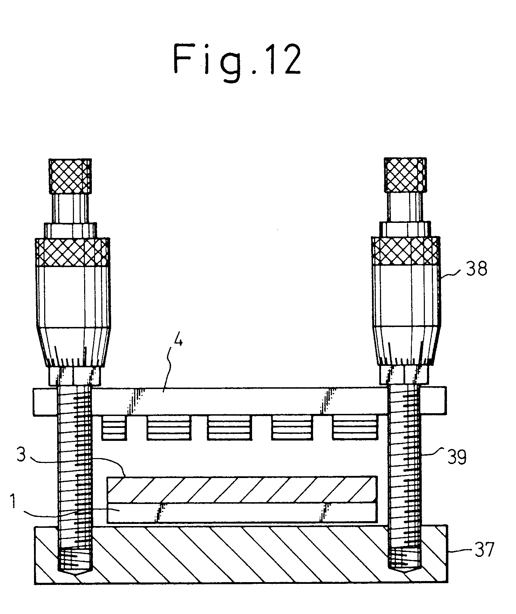

As shown in Fig. 12, use can be made of an apparatus integrally comprising a work station 37, on which the material 3 to be processed is placed, and screws 39 on which are mounted a mask 4, comprised of a transparent support substrate on which a dielectric multilayer film is selectively formed, and micrometer calipers 38. The distance from the surface of the films to be processed to the surface of the mask 4 was measured as follows: Firstly, the mask 4 was raised by the screws 39 to open up the distance between the mask 4 and the work station 37. The material to be processed, having a resin film 3 on its surface, was placed on the work station 37. Next, the mask 4 was lowered until lightly contacting the surface of the material to be processed, which position was used as a reference point (i.e. zero point). The mask was then gradually raised while viewing the micrometer calipers 38 and was stopped when a suitable position was reached.

Using the above method, a glass substrate 2 on which a polyimide film (Hitachi Kasei PIX-3500, thickness of 30 µm) was formed as a resin film 3 was processed by the exposure system shown in Figs. 4, 7 and 9 to form holes at a longitudinal and lateral pitch of 0.25 mm in a 3 cm square region.

The processing conditions were as shown below:
Laser oscillator: Lumonics EX-700
Oscillation wavelength: 248 nm (KrF)
Output: 300 mJ/pulse (pulse width 16 ns)
Exposure intensity: 1.0 J/cm² per pulse
Number or irradiation pulses: 200 pulses/shot
Reduction rate: 4:1
   The most suitable conditions for making via holes for interlayer connection having an opening diameter of 50 µm and a taper angle of 10° were studied, whereupon it was learned that use should be made of a mask with 40 µm hole diameters and the gap between the mask and film should be made 0.3 mm. Therefore, use was made of the apparatus of Fig. 12, employing a mask of appropriate diameter, the gap was set, and then the processing was performed. As a result, the opening diameter of the via holes formed was 40 µm and the taper angle was 12°, that is, the requirements were substantially met.

As explained above, in embodiments of the present invention, in ablation processing by an excimer laser the required laser irradiation can be performed adequately, so as to reduce the likelihood of defective connections through the via holes due to incomplete processing or damage to underlying electrode films. Even if fluctuations in laser output occur, deterioration of optical components occurs, or variations exist in the thickness of the processed film. The processing points are monitored, using the light emission due to the film ablation, so as to enable inspection for defects in processing to be carried out at the same time as the processing itself.

## Claims

1. An excimer laser ablation processing method of forming via holes in a resin film (3), by subjecting portions of that film to radiation from an excimer laser (11) and by employing light emitted as a result of decomposition of the irradiated portions of the film during formation of such holes to monitor progress of the hole formation,
characterised further by the steps of a) detecting the positions of said irradiated portions on the film (3) by using said emitted light, b) comparing the detected positions with respective preset design positions and c) using said comparison of said positions to inspect for processing defects.

2. A method as claimed in claim 1, wherein a mask (4) is interposed between the laser and the said resin film (3), which mask is transparent to such emitted light and has been made from a dielectric multilayer film by selectively patterning it to provide it with gaps for permitting the laser radiation to pass through the mask to the resin film, the said emitted light being used to detect the said positions after it has passed through the mask.

3. A method as claimed in claim 1 or 2, wherein the said resin film (3) is a layer of insulation material (3) forming part of a multilayer circuit substrate (1) of an electronic circuit device.

4. A method as claimed in claim 1, 2 or 3, wherein an oxygen gas atmosphere is maintained in the vicinity of the surface of the said resin film during formation of the said via holes.

5. A method as claimed in any preceding claim, wherein the irradiation of the said portions is terminated upon detection of a predetermined change in intensity of the emitted light.

6. An ablation processing apparatus, for use in forming via holes in a resin film (3), comprising means for subjecting portions of that film to radiation from an excimer laser (11), and means for monitoring the progress of the hole formation, whilst said portions are subjected to said radiation, by employing the light emitted as a result of decomposition of the irradiated portions of the film during formation of said holes,
characterised further by a) means for detecting the positions of said irradiated portions on the film by using said emitted light, b) means for comparing the detected positions with respective preset design positions and c) means for inspecting for processing defects by using said comparison of said positions.

7. An apparatus as claimed in claim 6, wherein a mask (4) is interposed between the laser and the said resin film (3), which mask is transparent to such emitted light and has been made from a dielectric multilayer film by selectively patterning it to provide it with gaps for permitting the laser radiation to pass through the mask to the resin film, the said inspection means being located so that the said emitted light is used thereby to detect the said positions, after it has passed through the mask.

8. An apparatus as claimed in claim 6 or 7, including means for maintaining an oxygen gas atmosphere in the vicinity of the surface of the said resin film during formation of the said via holes.

9. An apparatus as claimed in claim 6, 7 or 8, including means operable to detect changes in intensity of the emitted light and to terminate the irradiation of the said portions upon detection of a predetermined change in intensity of the emitted light.

## Patentansprüche

1. Excimerlaser-Abtragungsbearbeitungsverfahren zum Bilden von Durchgangslöchern in einem Harzfilm (3), indem Abschnitte von jenem Film einer Strahlung von einem Excimerlaser (11) ausgesetzt werden und Licht, das als Resultat einer Zersetzung der bestrahlten Abschnitte des Films während der Bildung von solchen Löchern emittiert wird, verwendet wird, um den Fortschritt der Lochbildung zu überwachen,
ferner gekennzeichnet durch die folgenden Schritte:
a) Detektieren der Positionen der bestrahlten Abschnitte auf dem Film (3) unter Verwendung des emittierten Lichtes, b) Vergleichen der detektierten Positionen mit jeweiligen vorgegebenen Konstruktionspositionen und c) Verwenden des Vergleichs der genannten Positionen, um eine Inspektion auf Bearbeitungsdefekte vorzunehmen.

2. Verfahren nach Anspruch 1, bei dem eine Maske (4) zwischen dem Laser und dem Harzfilm (3) angeordnet wird, welche Maske für solches emittiertes Licht transparent ist und aus einem dielektrischen mehrschichtigen Film durch dessen selektives Mustern hergestellt worden ist, um sie mit Lücken zu versehen, so daß die Laserstrahlung durch die Maske auf den Harzfilm gelangen kann, welches emittierte Licht verwendet wird, um die genannten Positionen zu detektieren, nachdem es durch die Maske hindurchgetreten ist.

3. Verfahren nach Anspruch 1 oder 2, bei dem der Harzfilm (3) eine Schicht aus Isoliermaterial (3) ist, die einen Teil eines mehrschichtigen Schaltungssubstrates (1) einer elektronischen Schaltungsvorrichtung bildet.

4. Verfahren nach Anspruch 1, 2 oder 3, bei dem eine Sauerstoffgasatmosphäre in der Nähe der Oberfläche des Harzfilms während der Bildung der Durchgangslöcher aufrechterhalten wird.

5. Verfahren nach irgendeinem vorhergehenden Anspruch, bei dem die Bestrahlung der genannten Abschnitte bei Detektion einer vorbestimmten Veränderung der Intensität des emittierten Lichtes beendet wird.

6. Abtragungsbearbeitungsvorrichtung zur Verwendung beim Bilden von Durchgangslöchern in einem Harzfilm (3), mit einem Mittel zum Aussetzen von Abschnitten jenes Films einer Strahlung von einem Excimerlaser (11) und einem Mittel zum Überwachen des Fortschrittes der Lochbildung, während die Abschnitte der Strahlung ausgesetzt werden, unter Verwendung des Lichtes, das als Resultat einer Zersetzung der bestrahlten Abschnitte des Films während der Bildung der Löcher emittiert wird,
ferner gekennzeichnet durch a) ein Mittel zum Detektieren der Positionen der bestrahlten Abschnitte auf dem Film unter Verwendung des emittierten Lichtes, b) ein Mittel zum Vergleichen der detektierten Positionen mit jeweiligen vorgegebenen Konstruktionspositionen und c) ein Mittel zum Vornehmen einer Inspektion auf Bearbeitungsdefekte unter Verwendung des Vergleichs der genannten Positionen.

7. Vorrichtung nach Anspruch 6, bei der eine Maske (4) zwischen dem Laser und dem Harzfilm (3) angeordnet ist, welche Maske für solches emittiertes Licht transparent ist und aus einem dielektrischen mehrschichtigen Film durch dessen selektives Mustern hergestellt worden ist, um sie mit Lücken zu versehen, so daß die Laserstrahlung durch die Maske auf den Harzfilm gelangen kann, welches Inspektionsmittel so angeordnet ist, daß das emittierte Licht dadurch verwendet wird, um die genannten Positionen, nachdem es durch die Maske hindurchgetreten ist, zu detektieren.

8. Vorrichtung nach Anspruch 6 oder 7, die ein Mittel enthält zum Aufrechterhalten einer Sauerstoffgasatmosphäre in der Nähe der Oberfläche des Harzfilms während der Bildung der Durchgangslöcher.

9. Vorrichtung nach Anspruch 6, 7 oder 8, mit einem Mittel, das betriebsfähig ist, um Veränderungen der Intensität des emittierten Lichtes zu detektieren und die Bestrahlung der genannten Abschnitte bei Detektion einer vorbestimmten Veränderung der Intensität des emittierten Lichtes zu beenden.

## Revendications

1. Procédé de traitement d'ablation au laser excimer consistant à former des trous traversants dans un film (3) de résine, en soumettant des parties de ce film à un rayonnement issu d'un laser excimer (11) et en employant la lumière émise comme résultat de décomposition des parties éclairées du film au cours de la formation de ces trous pour surveiller la progression de la formation de trous ;
caractérisé en outre par les étapes : a) de détection des positions desdites parties éclairées sur le film (3) en utilisant ladite lumière émise ; b) de comparaison des positions détectées avec des positions nominales préétablies respectives et c) d'utilisation de ladite comparaison desdites positions pour rechercher des défauts de traitement.

2. Procédé selon la revendication 1, dans lequel on interpose un masque (4) entre le laser et ledit film (3) de résine, lequel masque est transparent à une telle lumière émise et a été fait d'un film multicouche diélectrique en le dessinant de manière sélective pour le munir d'espaces destinés à permettre au rayonnement de laser de passer à travers le masque jusqu'au film de résine, ladite lumière émise étant utilisée pour détecter lesdites positions après avoir traversé le masque.

3. Procédé selon la revendication 1 ou 2, dans lequel ledit film (3) de résine est une couche de matière isolante (3) faisant partie d'un substrat (1) de circuit multicouche d'un dispositif de circuit électronique.

4. Procédé selon la revendication 1, 2 ou 3, dans lequel on maintient une atmosphère d'oxygène gazeux au voisinage de la surface dudit film de résine pendant la formation desdits trous traversants.

5. Procédé selon l'une quelconque des revendications précédentes, dans lequel l'éclairement desdites parties se termine lors de la détection d'un changement prédéterminé d'intensité de la lumière émise.

6. Appareil de traitement par ablation destiné à être utilisé à la formation de trous traversants dans un film (3) de résine, comprenant un moyen destiné à soumettre des parties de ce film à un rayonnement issu d'un laser excimer (11), et un moyen destiné à surveiller la progression de la formation de trous, tandis que lesdites parties sont soumises audit rayonnement, en employant la lumière émise comme résultat de décomposition des parties éclairées du film pendant la formation desdits trous,
caractérisé en outre par a) un moyen destiné à détecter les positions desdites parties éclairées sur le film en utilisant ladite lumière émise ; b) un moyen destiné à comparer les positions détectées avec des positions nominales préétablies respectives et c) un moyen destiné à rechercher des défauts de traitement en utilisant ladite comparaison desdites positions.

7. Appareil selon la revendication 6, dans lequel on interpose un masque (4) entre le laser et ledit film (3) de résine, lequel masque est transparent à une telle lumière émise et a été fait d'un film multicouche diélectrique en le dessinant de manière sélective pour le munir d'espaces destinés à permettre au rayonnement de laser de passer à travers le masque jusqu'au film de résine, ledit moyen d'inspection étant situé de façon que ladite lumière émise soit utilisée ainsi pour détecter lesdites positions, après qu'elle a traversé le masque.

8. Appareil selon la revendication 6 ou 7, incluant un moyen destiné à maintenir une atmosphère d'oxygène gazeux au voisinage de la surface dudit film de résine pendant la formation desdits trous traversants.

9. Appareil selon la revendication 6, 7 ou 8, incluant un moyen pouvant être mis en oeuvre pour détecter des changements d'intensité de la lumière émise et pour mettre fin à l'éclairement desdites parties lors de la détection d'un changement d'intensité prédéterminé de la lumière émise.
